# EUROPEAN PATENT SPECIFICATION

(11) **EP 1 809 789 B1**
(45) Date of publication and mention of the grant of the patent: **09.12.2015**
(21) Application number: 04791876.8
(22) Date of filing: 01.10.2004
(51) Int. Cl.: C23C 16/52

(54) **EPITAXIAL REACTOR COOLING METHOD AND REACTOR COOLED THEREBY**
VERFAHREN ZUM ABKÜHLEN EINES EPITAXIEREAKTORS UND DADURCH GEKÜHLTER REAKTOR
PROCEDE DE REFROIDISSEMENT DE REACTEUR D'EPITAXIE ET REACTEUR AINSI REFROIDI

(43) Date of publication of application: 25.07.2007
(73) Proprietor: LPE SPA, 20021 Bollate MI (IT)
(72) Inventor: OGLIARI, Vincenzo, I-26010 Capergnanica (Cremona) (IT); TARENZI, Giuseppe, I-26823 Castiglione d'Adda (IT); PUGLISI, Marco, I-95100 Catania (IT); SPECIALE, Natale, I-91020 Mazara del Vallo (IT); PRETI, Franco, I-20133 Milano (IT)
(74) Representative: Dragotti, Gianfranco
(86) International application number: PCT/IT2004/000542
(87) International publication number: WO 2006/038228

(56) References cited:
- EP-A- 0 147 967
- US-A- 4 293 755
- US-B1- 6 639 196
- PATENT ABSTRACTS OF JAPAN vol. 007, no. 255 (E-210), 12 November 1983 (1983-11-12) & JP 58 141523 A (TOKYO SHIBAURA DENKI KK), 22 August 1983 (1983-08-22)
- PATENT ABSTRACTS OF JAPAN vol. 014, no. 457 (E-0986), 2 October 1990 (1990-10-02) & JP 02 184020 A (NISSIN ELECTRIC CO LTD), 18 July 1990 (1990-07-18)

## Description

The invention relates to a method for cooling the chamber of an epitaxial reactor used in the production of substrates by chemical vapour deposition (the CVD process).

As is known, these reactors are above all used in the microelectronics industry for the production of semiconductor components; to this end they comprise a reaction chamber in which the epitaxial growth of the substrates (also commonly known as wafers) takes place, with the substrates being supported by a susceptor.

There are two types of reactor, defined in relation to the path of the reaction gases: horizontal reactors and vertical reactors.

The method of the present invention relates to both types of reactor, although in the description below reference will be made chiefly to the former, wherein the reaction chamber is substantially a quartz bell with a vaguely parallelepipedal shape, crossed horizontally by the flow of gases from one side to the other.

In horizontal reactors, the susceptor comprises a disc that rotates inside the reaction chamber and the substrates are located on its upper surface in respective seats of corresponding shape. The susceptor disc is usually made of graphite or another conductive material able to withstand high temperatures so that it can be heated using electromagnetic induction or radiance with lamps.

The CVD process is the result of a chemical reaction that takes place at high temperatures (above 1.000°C), such that it is a known practice to cool the walls, generally quartz, of the reaction chamber. JP58-141523 disloses an example of prior art. The cooling may be with air or water: it should, however, not be excessive because if the wall temperature decreases below preset levels, there is a risk.

This risk concerns mainly the zones of the chamber that are less hot and is accentuated in the case where the cooling fluid is water, since its heat exchange with the quartz bell is greater than that of air.

The technical problem underlying the present invention is therefore to cool an epitaxial reactor in such a way as to prevent excessive lowering of the temperature, that could cause the aforementioned negative consequences.

This problem is solved by a method as defined in claim 1.

According to a preferred embodiment, when the method according to the invention is carried out in horizontal reactors, the reaction chamber is cooled by water (or another appropriate liquid) sprayed in the zone above the susceptor disc. The invention also comprises an epitaxial reactor cooled in accordance with the method as claimed, and a reaction chamber purposely made. Further features of the invention will emerge more clearly from the following description of a non-limiting example of the invention, shown in the accompanying drawings wherein:
- Fig. 1 is a diagrammatic perspective view of an epitaxial reactor cooled according to the present invention;
- Fig. 2 is a plan view of the reaction chamber of the reactor in Fig. 1;
- Fig. 3 is a side view of the reaction chamber in Fig. 2;
- Fig. 4 is a diagrammatic representation of the cooling fluxes in the preceding reaction chamber.

In these drawings, the reference 1 generally indicates an epitaxial reactor for the chemical vapour deposition (CVD) of substances, like those typically used for the production of semiconductors in the microelectronics industry.

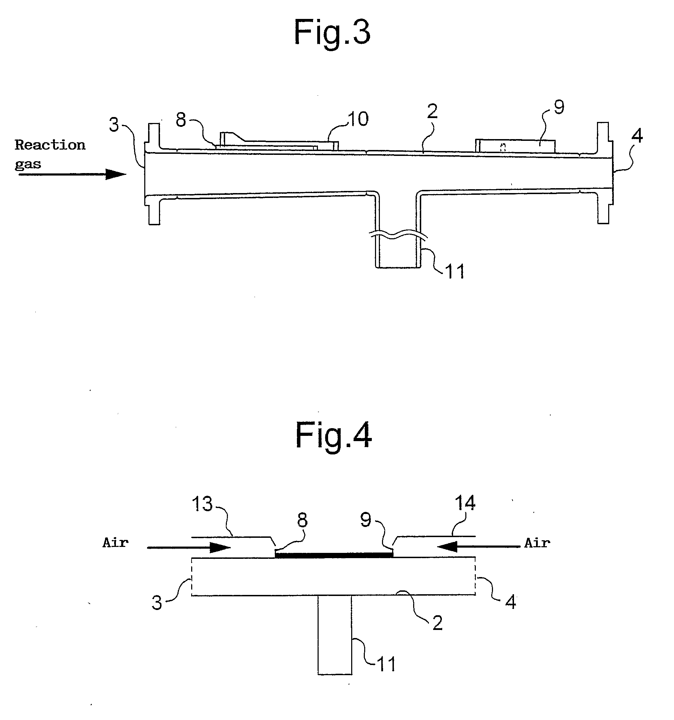

The reactor 1 is of the horizontal flow type and comprises a reaction chamber 2 with a substantially parallelepipedal shape, that has an inlet opening 3 and an outlet opening 4 on two opposite faces for the flow of gases in the reaction chamber, the velocity of which is indicated by the arrow in Fig. 3.

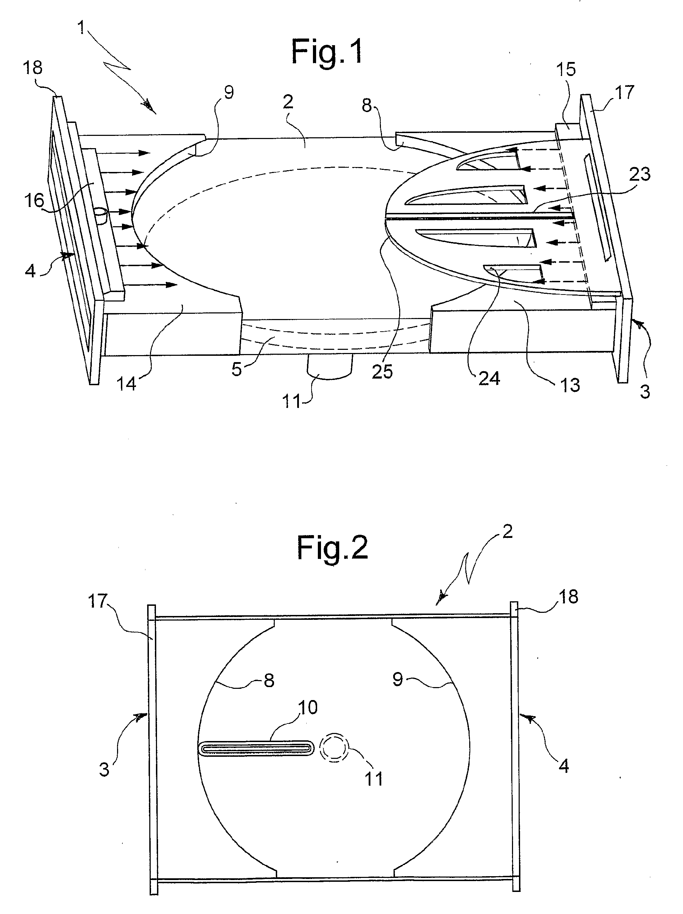

The reaction chamber 2 is made of quartz and is slightly tapered towards the gas outlet side, while in the zone above the susceptor disc 5 (indicated only by the broken lines in Fig. 1), it is coated preferably by a thin layer of gold paint that reflects the heat radiated during the process.

The zone of the chamber 2 located above the susceptor 5 is delimited by two circular-arc-shaped ribs 8, 9 that extend from one side of the chamber to the other; moreover, the chamber is provided with a radial window 10 known *per se* for the use of optical means for monitoring the susceptor position.

The lower part of the chamber 2 has the usual hollow stem 11 through which the shaft for rotating the susceptor 5 extends. This shaft is not shown in the drawings. As can be seen in Figure 1, in connection with the inlet and outlet openings 3 and 4 of the chamber, there are respective screens 13 and 14; the latter are coverings made of sheet metal or another appropriate material, which extend around the zones of the reaction chamber 2 that are outside the ribs 8 and 9.

The purpose of the screens is to prevent the cooling water supplied using the distributors 15 and 16 from falling into the zones of the chamber 2 that are furthest from the susceptor and therefore have a lower temperature. To this end, the screens 13, 14 are fixed to flanges 17, 18 associated with the inlet and outlet openings 3 and 4, and have their free edge shaped in the same manner as the ribs 8, 9. The distance between the screens and the quartz of the chamber 2 is preferably approximately 10 mm.

In a preferred embodiment of the invention there is, above the screen 13, a plate 23 that supports additional nozzles 24, 25 for also spraying water above the central zone of the reaction chamber 2.

The description provided hereinabove makes it possible to understand how the reactor 1 is cooled in accordance with the method of the invention.

The distributors 15, 16 feed the water over the respective screens 13, 14 as indicated by the arrows in Fig. 1. The water then flows in a cascade along the curved edge of aforesaid screens and falls onto the reaction chamber 2, in the zone of the latter that is above the susceptor between ribs 8 and 9.

The ribs in fact form barriers that prevent the water from flowing back towards the openings 3 and 4, so that it falls laterally along the free edge of the chamber 2 between the two ribs 8 and 9, to be collected subsequently in a tank located underneath and not shown in the drawings.

A third flow of water is sprayed by the nozzles 24, 25 with some velocity towards the central part of the chamber 2. This is the most critical zone, since it is subjected to the greatest heat flux from the susceptor and the moving water can exchange heat with the quartz better, thereby avoiding harmful boiling phenomena that could cause the detachment of the reflective paint applied in this zone.

The selective cooling thus provided makes it possible to maintain substantially uniform temperature distribution in the quartz of the reaction chamber 2, since coolest zones thereof (that is to say, those furthest away from the susceptor 5) are not sprinkled with water while its central zones are constantly sprayed to remove the heat radiated by the susceptor below.

In particular, it can be said that there is a high heat flux or power (i.e. the quantity of heat per unit of time) removal from the part sprinkled with water by forced convection, whereas the heat flux removed in the dry zones is less and the exchange takes place by natural air convection and radiation.

It should however be noted that in order to obtain either greater cooling or better process control, the dry zones can be licked by forced ventilation that circulates air between the upper wall of the chamber 2 and the screens 13, 14, as indicated diagrammatically in Figure 4. In this case, these zones are therefore cooled by forced convection.

The uniform temperature distribution obtained using the method of the invention enables easier and more effective control of the conditions of the reaction chamber 2, in order to prevent excessive drops in temperature that could have the aforementioned damaging consequences (polymerisation of the gaseous substances and their subsequent condensation or deposition on the chamber walls).

It is clear that the teaching of selectively cooling the reaction chamber can also be carried out differently from the embodiment explained above, to suit the different epitaxial reactors (both horizontal and vertical) in use.

For example, the fact that only the upper zone of the reaction chamber 2 is water cooled as described above, does not prevent its lower part from also being cooled using the same principle.

In this case it will be necessary to provide means for spraying water from below towards the zone of the chamber that is underneath the susceptor 5 and around the hollow stem 11.

It should also be understood that a known cooling system can alternatively be installed under the reaction chamber, such as, for example the system described in European Patent No. 730679, in the name of the same present applicant.

In this connection, it should be emphasised that the selective cooling of the present invention makes it possible to apply the reflective gold coating, only in the zone where the susceptor radiation is greatest. In the previous example, this zone is the one sprinkled with water between the two ribs 8 and 9.

This has two advantages: firstly that the painting is simplified and less costly, given that it does not coat the whole reaction chamber 2, but only one part of it; secondly that, since the zones subjected to greater radiation are water cooled, the temperature of the quartz on the water side is relatively cool.

Conversely, where there is no water, notwithstanding the fact that there is less radiation, the temperature is higher on the outer side of the chamber 2 and this causes the gold coating to detach irrespective of whether it is applied by painting or deposited by other methods (PVD for example), since gold (or other metals) has a greater thermal expansion coefficient than quartz (in the order of 5 x 10⁻⁷ 1/K).

In these zones where there is no water, the losses due to radiation can however be reduced by using screens 13 and 14, which thus act as reflectors. In this case, screens 13 and 14 can be made of metal material and/or optionally coated with gold or another highly-reflective material.

Lastly, it should be noted that the selective cooling of the reaction chamber can also be applied to vertical epitaxial reactors, with possible modifications due to the truncated-pyramid shape of the susceptor and of the bell shape of the reaction chamber.

These and other embodiments fall nevertheless within the scope of the following claims.

## Claims

1. Method of cooling the reaction chamber (2) made of quartz of a reactor (1) for chemical vapour deposition, wherein at least one predetermined zone of the wall of the reaction chamber (2) is selectively cooled with a fluid in order to remove a different heat flux compared with the adjacent zones, thereby obtaining a substantially uniform temperature distribution of the reaction chamber (2), **characterised in that** the fluid used for selectively cooling said at least one zone is water or another liquid, whereas the adjacent zones are cooled using air or another gas, the reaction chamber (2) containing a susceptor (5) and said at least one selectively-cooled zone being in a position that is substantially in front of the susceptor (5).

2. Method according to claim 1 , wherein the at least one selectively-cooled zone is separated from the adjacent zones to avoid the fluid from passing from the former to the latter.

3. Method according to claim 1 or 2, wherein said air or other gas is supplied using forced ventilation.

4. Reactor (1) for chemical vapour deposition adapted to carry out the method according to any one of the preceding claims, comprising a reaction chamber (2) made of quartz, a susceptor (5) placed in said reaction chamber, means (15, 16, 24, 25) for selectively distributing a cooling fluid on at least one predetermined zone of the reaction chamber (2), said cooling fluid being water or another liquid, **characterized by** being adapted to cool zones of the reaction chamber (2) adjacent to said predetermined zone through air or another gas, said at least one selectively-cooled zone being in a position that is substantially in front of the susceptor (5) and the reactor comprising a screening (13, 14) fitted to the reaction chamber (2) in order to prevent the fluid from licking the zones adjacent to the selectively-cooled zone.

5. Reactor according to claim 4, comprising means for supplying said air or other gas using forced ventilation.

6. Reactor according to claim 4, wherein the reaction chamber (2) comprises a ribbing (8, 9) on its surface suitable for delimiting said selectively-cooled zone from the zones adjacent thereto.

7. Reactor according to claim 4 or 6, wherein the susceptor (5) is a disc susceptor and the reaction chamber (2) has a substantially parallelepipedal shape with an inlet opening (3) and an outlet opening (4) on respective opposite faces for the flow of the reaction gases in a substantially-horizontal direction, and wherein the screening (13, 14) extends from said opposite faces, leaving the zone above the susceptor free.

8. Reactor according to claim 4 or 6 or 7, wherein the cooling liquid is distributed over the screening (13, 14) from which it flows over the zone of the reaction chamber (2) that is located above the susceptor (5).

9. Reactor according to claim 6 or 7 or 8, wherein said ribbing (8, 9) is substantially arcuate for delimiting the zone of the reaction chamber (2) that is located above the susceptor (5) and the zone of the reaction chamber (2) above the susceptor (5) which is delimited by the ribbing (8, 9) is open on the sides to let the cooling liquid flow out laterally.

10. Reactor according to any one of claims from 4 to 9, comprising nozzles (24, 25) that are suitable for spraying the cooling liquid centrally with respect to the zone of the reaction chamber (2) that is located above the susceptor (5).

11. Reactor according to any one of claims from 4 to 10, wherein the selectively-cooled zone of the reaction chamber (2) is coated with a reflective layer.

12. Reactor according to any one of the preceding claims, wherein the screening (13, 14) is fitted to the reaction chamber (2) and is made of metal material or coated with reflective material.

13. Reaction chamber for a reactor according to any one of claims from 4 to 12, having a substantially parallel epipedal shape and comprising a ribbing (8, 9) on its surface suitable for delimiting a selectively-cooled zone from zones adjacent thereto.

14. Reaction chamber according to claim 13, comprising on its upper surface a pair of substantially arcuate ribs (8, 9), that extend preferably from one side of the chamber to the other side, to delimit the selectively-cooled zone.

15. Reaction chamber according to claim 14, wherein the zone delimited by said ribs (8, 9) is coated with a reflective layer.

## Patentansprüche

1. Verfahren zum Kühlen der Reaktionskammer (2) aus Quarz eines Reaktors (1) für chemische Dampfdeposition, wobei zumindest eine vorbestimmte Zone der Wand der Reaktionskammer (2) selektiv mit einem Fluid gekühlt wird, um einen abweichenden Wärmefluss verglichen mit den benachbarten Zonen zu beheben, wodurch eine im Wesentlichen gleichmäßige Temperaturverteilung der Reaktionskammer (2) erhalten wird, **dadurch gekennzeichnet, dass** das für das selektive Kühlen der zumindest einen Zone verwendete Fluid Wasser oder eine andere Flüssigkeit ist, während die benachbarten Zonen unter Verwendung von Luft oder einem anderen Gas gekühlt werden, wobei die Reaktionskammer (2) einen Susceptor (5) aufweist und die zumindest eine selektiv gekühlte Zone in einer Position ist, die im Wesentlichen vor dem Susceptor (5) ist.

2. Verfahren nach Anspruch 1, wobei die zumindest eine selektiv gekühlte Zone von den benachbarten Zonen getrennt ist, um zu verhindern, dass das Fluid von der erstgenannten zu den letztgenannten gelangt.

3. Verfahren nach Anspruch 1 oder 2, wobei die Luft oder das andere Gas unter Druckventilation zugeführt wird.

4. Reaktor (1) für chemische Dampfdeposition, der dazu angepasst ist, das Verfahren nach einem der vorhergehenden Ansprüche durchzuführen, umfassend eine Reaktionskammer (2) aus Quarz, einen Susceptor (5), der in der Reaktionskammer platziert ist, Mittel (15, 16, 24, 25) zum selektiven Verteilen eines Kühlfluids auf zumindest eine vorbestimmte Zone der Reaktionskammer (2), wobei das Kühlfluid Wasser oder eine andere Flüssigkeit ist, **dadurch gekennzeichnet, dass** er dazu angepasst ist, Zonen der Reaktionskammer (2), die benachbart zu der vorbestimmten Zone sind, durch Luft oder ein anderes Gas zu kühlen, wobei die zumindest eine selektiv gekühlte Zone in einer Position ist, die im Wesentlichen vor dem Susceptor (5) ist, und der Reaktor ein Sieb (13, 14) umfasst, das an die Reaktionskammer (2) gefügt ist, um zu verhindern, dass das Fluid in die bezüglich der selektiv gekühlten Zone benachbarten Zonen abgelenkt wird.

5. Reaktor nach Anspruch 4, umfassend Mittel zum Zuführen der Luft oder des anderen Gases unter Verwendung von Druckventilation.

6. Reaktor nach Anspruch 4, wobei die Reaktionskammer (2) Rippen (8, 9) auf ihrer Oberfläche aufweist, die dazu geeignet sind, die selektiv gekühlte Zone von den hierzu benachbarten Zonen abzugrenzen.

7. Reaktor nach Anspruch 4 oder 6, wobei der Susceptor (5) ein Scheibensusceptor ist und die Reaktionskammer (2) eine im Wesentlichen parallelepipedische Form mit einer Einlassöffnung (3) und einer Auslassöffnung (4) auf jeweils gegenüberliegenden Flächen für die Strömung des Reaktionsgases in einer im Wesentlichen horizontalen Richtung aufweist und wobei das Sieb (13, 14) sich von den gegenüberliegenden Flächen aus erstreckt, wobei die Zone oberhalb des Susceptors freigelassen ist.

8. Reaktor nach Anspruch 4 oder 6 oder 7, wobei die Kühlflüssigkeit über das Sieb (13, 14) verteilt wird, von dem sie über die Zone der Reaktionskammer (2) fließt, die oberhalb des Susceptors (5) angeordnet ist.

9. Reaktor nach Anspruch 6 oder 7 oder 8, wobei die Rippen (8, 9) im Wesentlichen gebogen sind, um die Zone der Reaktionskammer (2), die oberhalb des Susceptors (5) angeordnet ist, abzugrenzen, und die Zone der Reaktionskammer (2) oberhalb des Susceptors (5), die durch die Rippen (8,9) abgegrenzt ist, auf den Seiten offen ist, um die Kühlflüssigkeit seitlich ausfließen zu lassen.

10. Reaktor nach einem der Ansprüche 4-9, umfassend Düsen (24, 25), die geeignet sind, die Kühlflüssigkeit zentral in Bezug auf die Zone der Reaktionskammer (2), die oberhalb des Susceptors (5) angeordnet ist, zu sprühen.

11. Reaktor nach einem der Ansprüche 4-10, wobei die selektiv gekühlte Zone der Reaktionskammer (2) mit einer Reflexionsschicht beschichtet ist.

12. Reaktor nach einem der vorhergehenden Ansprüche, wobei das Sieb (13,14) an die Reaktionskammer (2) gefügt ist und aus Metallmaterial hergestellt oder mit reflektierendem Material beschichtet ist.

13. Reaktionskammer für einen Reaktor nach einem der Ansprüche 4-12 mit einer im Wesentlichen parallelepipedischen Form und umfassend Rippen (8, 9) auf ihrer Oberfläche, die zum Abgrenzen einer selektiv gekühlten Zone von hierzu benachbarten Zonen geeignet ist.

14. Reaktionskammer nach Anspruch 13, umfassend auf ihrer oberen Oberfläche ein Paar von im Wesentlichen bogenförmigen Rippen (8, 9), die sich bevorzugt von einer Seite der Kammer zu der anderen Seite erstrecken, um die selektiv gekühlte Zone zu begrenzen.

15. Reaktionskammer nach Anspruch 14, wobei die durch die Rippen (8, 9) abgegrenzte Zone mit einer reflektierenden Schicht beschichtet ist.

## Revendications

1. Procédé pour refroidir la chambre de réaction (2) réalisée à partir de quartz d'un réacteur (1) pour le dépôt chimique en phase vapeur, dans lequel au moins une zone prédéterminée de la paroi de la chambre de réaction (2) est sélectivement refroidie avec un fluide afin de supprimer un flux thermique différent par rapport aux zones adjacentes, obtenant ainsi une répartition de température sensiblement uniforme de la chambre de réaction (2), **caractérisé en ce que** le fluide utilisé pour refroidir sélectivement ladite au moins une zone est l'eau ou un autre liquide, alors que les zones adjacentes sont refroidies en utilisant de l'air ou un autre gaz, la chambre de réaction (2) contenant un suscepteur (5) et ladite au moins une zone sélectivement refroidie étant dans une position qui est sensiblement en face du suscepteur (5).

2. Procédé selon la revendication 1, dans lequel la au moins une zone sélectivement refroidie est séparée des zones adjacentes pour éviter que le fluide ne passe de la première à la dernière.

3. Procédé selon la revendication 1 ou 2, dans lequel ledit air ou autre gaz est fourni en utilisant la ventilation forcée.

4. Réacteur (1) pour le dépôt chimique en phase vapeur adapté pour réaliser le procédé selon l'une quelconque des revendications précédentes, comprenant une chambre de réaction (2) réalisée à partir de quartz, un suscepteur (5) placé dans ladite chambre de réaction, des moyens (15, 16, 24, 25) pour distribuer sélectivement un fluide de refroidissement sur au moins une zone prédéterminée de la chambre de réaction (2), ledit fluide de refroidissement étant de l'eau ou un autre liquide, **caractérisé en ce qu'**il est adapté pour refroidir des zones de la chambre de réaction (2) adjacentes à ladite zone prédéterminée par le biais de l'air ou d'un autre gaz, ladite au moins une zone sélectivement refroidie étant dans une position qui est sensiblement en face du suscepteur (5) et le réacteur comprenant un blindage (13, 14) monté sur la chambre de réaction (2) afin d'empêcher le fluide d'humecter les zones adjacentes à la zone sélectivement refroidie.

5. Réacteur selon la revendication 4, comprenant des moyens pour amener ledit air ou autre gaz en utilisant la ventilation forcée.

6. Réacteur selon la revendication 4, dans lequel la chambre de réaction (2) comprend un nervurage (8, 9) sur sa surface, approprié pour délimiter ladite zone sélectivement refroidie, des zones adjacentes à cette dernière.

7. Réacteur selon la revendication 4 ou 6, dans lequel le suscepteur (5) est un suscepteur à disque et la chambre de réaction (2) a une forme sensiblement parallélépipédique avec une ouverture d'entrée (3) et une ouverture de sortie (4) sur des faces opposées respectives pour l'écoulement des gaz de réaction dans une direction sensiblement horizontale, et dans lequel le blindage (13, 14) s'étend à partir desdites faces opposées, laissant la zone au-dessus du suscepteur, libre.

8. Réacteur selon la revendication 4 ou 6 ou 7, dans lequel le liquide de refroidissement est réparti sur le blindage (13, 14) à partir duquel il s'écoule sur la zone de la chambre de réaction (2) qui est positionnée au-dessus du suscepteur (5).

9. Réacteur selon la revendication 6 ou 7 ou 8, dans lequel ledit nervurage (8, 9) est sensiblement arqué pour délimiter la zone de la chambre de réaction (2) qui est située au-dessus du suscepteur (5) et la zone de la chambre de réaction (2) au-dessus du suscepteur (5) qui est délimitée par le nervurage (8, 9) est ouverte sur les côtés pour laisser le liquide de refroidissement sortir en s'écoulant latéralement.

10. Réacteur selon l'une quelconque des revendications 4 à 9, comprenant des buses (24, 25) qui sont appropriées pour pulvériser le liquide de refroidissement centralement par rapport à la zone de la chambre de réaction (2) qui est positionnée au-dessus du suscepteur (5).

11. Réacteur selon l'une quelconque des revendications 4 à 10, dans lequel la zone sélectivement refroidie de la chambre de réaction (2) est recouverte avec une couche réfléchissante.

12. Réacteur selon l'une quelconque des revendications précédentes, dans lequel le blindage (13, 14) est monté sur la chambre de réaction (2) et est réalisé à partir d'un matériau métallique ou recouvert avec le matériau réfléchissant.

13. Chambre de réaction pour un réacteur selon l'une quelconque des revendications 4 à 12, ayant une forme sensiblement parallélépipédique et comprenant un nervurage (8, 9) sur sa surface, approprié pour délimiter une zone sélectivement refroidie, par rapport aux zones adjacentes à cette dernière.

14. Chambre de réaction selon la revendication 13, comprenant sur sa surface supérieure, une paire de nervures sensiblement arquées (8, 9) qui s'étendent de préférence à partir d'un côté de la chambre vers l'autre côté, afin de délimiter la zone sélectivement refroidie.

15. Chambre de réaction selon la revendication 14, dans laquelle la zone délimitée par lesdites nervures (8, 9) est recouverte avec une couche réfléchissante.
